(19) Europäisches Patentamt
European Patent Office
Office européen des brevets

(11) **EP 3 594 943 B1**

(12) **EUROPEAN PATENT SPECIFICATION**

(45) Date of publication and mention
of the grant of the patent:
**21.02.2024 Bulletin 2024/08**

(21) Application number: **19194667.2**

(22) Date of filing: **12.03.2012**

(51) International Patent Classification (IPC):
**G10L 19/02** (2013.01)   **G10L 19/00** (2013.01)
**G10L 19/032** (2013.01)

(52) Cooperative Patent Classification (CPC):
**G10L 19/032; G10L 19/0017; G10L 19/0208**

(54) **DEVICE AND METHOD FOR EXECUTION OF HUFFMAN CODING**

VORRICHTUNG UND VERFAHREN ZUR AUSFÜHRUNG EINER HUFFMAN-CODIERUNG

DISPOSITIF ET PROCÉDÉ POUR L'EXÉCUTION D'UN CODAGE DE HUFFMAN

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **20.04.2011 JP 2011094295
15.06.2011 JP 2011133432**

(43) Date of publication of application:
**15.01.2020 Bulletin 2020/03**

(60) Divisional application:
**23217545.5 / 4 322 161**

(62) Document number(s) of the earlier application(s) in
accordance with Art. 76 EPC:
**16175414.8 / 3 096 315
12774449.8 / 2 701 144**

(73) Proprietor: **Panasonic Holdings Corporation
Osaka 571-8501 (JP)**

(72) Inventors:
• **LIU, Zongxian**
**469332 Singapore (SG)**
• **CHONG, Kok Seng**
**469332 Singapore (SG)**
• **OSHIKIRI, Masahiro**
**Osaka-shi, Osaka 540-6207 (JP)**

(74) Representative: **Grünecker Patent- und
Rechtsanwälte
PartG mbB
Leopoldstraße 4
80802 München (DE)**

(56) References cited:
JP-A- 2002 268 693     US-A1- 2006 074 693
US-A1- 2010 106 511     US-B1- 7 668 715

**Description**

Technical Field

The present invention relates to an audio/speech encoding apparatus, audio/speech decoding apparatus and audio/speech encoding and decoding methods using Huffman coding.

Background Art

In signal compression, Huffman coding is widely used to encode an input signal utilizing a variable-length (VL) code table (Huffman table). Huffman coding is more efficient than fixed-length (FL) coding for the input signal which has a statistical distribution that is not uniform.

In Huffman coding, the Huffman table is derived in a particular way based on the estimated probability of occurrence for each possible value of the input signal. During encoding, each input signal value is mapped to a particular variable length code in the Huffman table.

By encoding signal values that are statistically more likely to occur using relatively short VL codes (using relatively few bits), and conversely encoding signal values that are statistically infrequently to occur using relatively long VL codes (using relatively more bits), the total number of bits used to encode the input signal can be reduced. Patent document JP 2002 268693 A (MITSUBISHI ELECTRIC CORP), 20 September 2002 relates to increasing the efficiency of auxiliary information used in audio encoding and performing adaptive processing for each of a plurality of frequency sections.

Citation List

[Non-patent document 1] ITU-T Recommendation G.719 (06/2008) "Low-complexity, full-band audio coding for high-quality, conversational applications" JP 2002-268693 A relates to a processing section determination part which sets a plurality of processing sections on a frequency axis in the encoding of a conversion coefficient so that the sections are less than prescribed minimum unit sections. An optimum encoding processing part encodes the conversion coefficient calculated by an orthogonal conversion part, set by the determination part, according to an index for adaptively controlling the generation amount of quantization noise calculated by an auditory analysis part and outputs the encoded conversion coefficient and the attached auxiliary information having been used for the encoding.

Summary of Invention

It is an object of the invention to overcome the shortcomings in the prior art. This object of the invention is solved by the independent claims. Specific embodiments are defined in the dependent claims. Any reference to inventions or embodiments not falling within the scope of the independent claims are to be interpreted as examples useful for understanding the invention.

Technical Problem

In some applications, such as audio signal encoding, the signal statistics may vary significantly from one set of audio signal to another set of audio signal. And even within the same set of audio signal.

If the statistics of the audio signal varies drastically from the statistics of the predefined Huffman table, the encoding of the signal can not be optimally done. And it happens that, to encode the audio signal which has different statistics, the bits consumption by Huffman coding is much more than the bits consumption by fixed length coding.

One possible solution is to include both the Huffman coding and fixed length coding in the encoding, and the encoding method which consumes fewer bits are selected. One flag signal is transmitted to decoder side to indicate which coding method is selected in encoder. This solution is utilized in a newly standardized ITU-T speech codec G.719.

The solution solves the problem for some very extreme sequences in which the Huffman coding consumes more bits than the fixed length coding. But for other input signals which have different statistics from the Huffman table but still select the Huffman coding, it is still not optimal.

In ITU-T standardized speech codec G.719, Huffman coding is used in encoding of the norm factors' quantization indices.

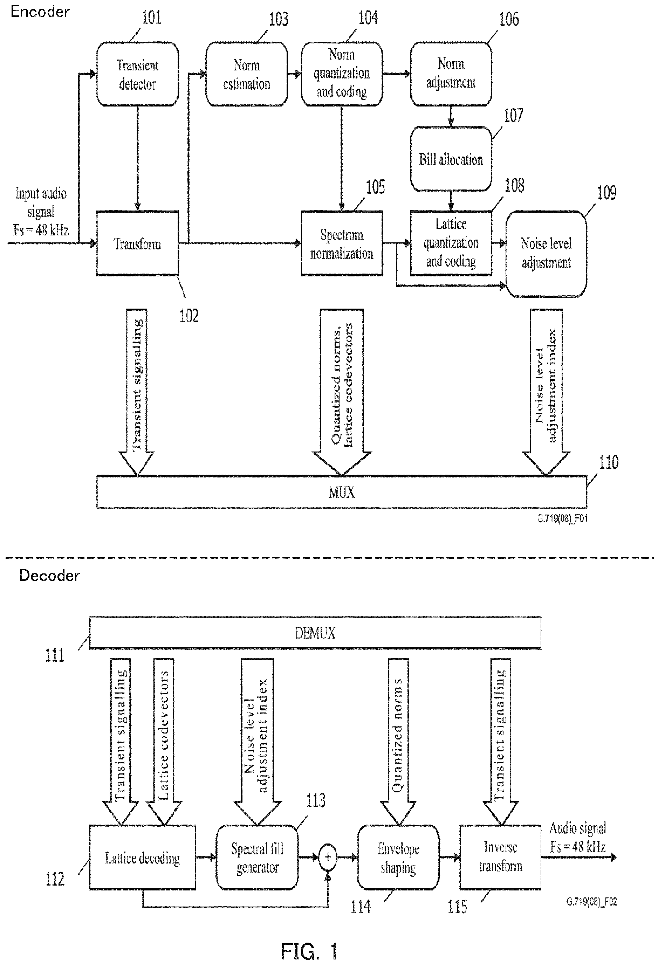

The structure of G.719 is illustrated in Figure 1.

At encoder side, the input signal sampled at 48 kHz is processed through a transient detector (101). Depending on the detection of a transient, a high frequency resolution or a low frequency resolution transform (102) is applied on the input signal frame. The obtained spectral coefficients are grouped into bands of unequal lengths. The norm of each band is estimated (103) and resulting spectral envelope consisting of the norms of all bands is quantized and encoded (104). The coefficients are then normalized by the quantized norms (105). The quantized norms are further adjusted (106) based on adaptive spectral weighting and used as input for bit allocation (107). The normalized spectral coefficients are lattice-vector quantized and encoded (108) based on the allocated bits for each frequency band. The level of the non-coded spectral coefficients is estimated, coded (109) and transmitted to the decoder. Huffman encoding is applied to quantization indices for both the coded spectral coefficients as well as the encoded norms.

At decoder side, the transient flag is first decoded which indicates the frame configuration, i.e., stationary or transient. The spectral envelope is decoded and the same, bit-exact, norm adjustments and bit-allocation algorithms are used at the decoder to recompute the bit-allocation which is essential for decoding quantization indices of the normalized transform coefficients. After de-quantization (112), low frequency non-coded spectral coefficients (allocated zero bits) are regenerated by using a spectral-fill codebook built from the received spectral coefficients (spectral coefficients with non-zero bit allocation) (113). Noise level adjustment index is used to adjust the level of the regenerated coefficients. High frequency non-coded spectral coefficients are regenerated using bandwidth extension. The decoded spectral coefficients and regenerated spectral coefficients are mixed and lead to normalized spectrum. The decoded spectral envelope is applied leading to the decoded full-band spectrum (114). Finally, the inverse transform (115) is applied to recover the time-domain decoded signal. This is performed by applying either the inverse modified discrete cosine transform for stationary modes, or the inverse of the higher temporal resolution transform for transient mode.

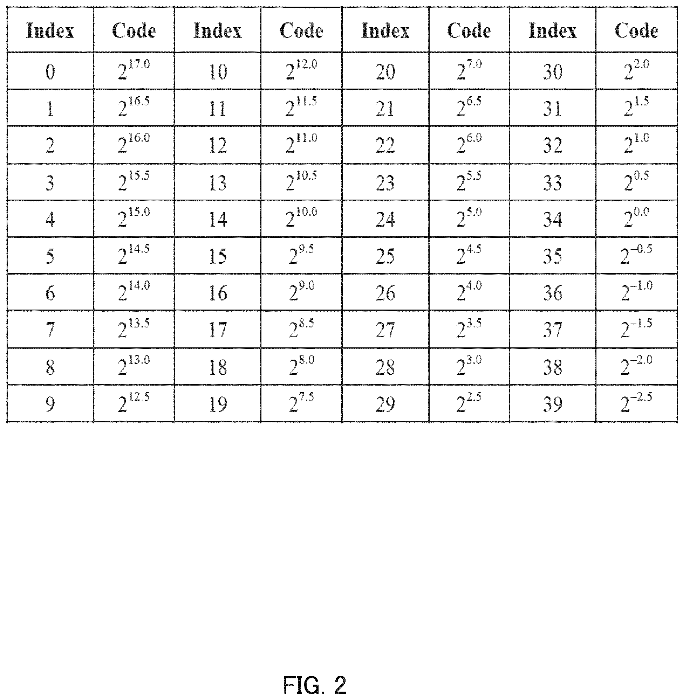

In encoder (104), the norm factors of the spectral sub bands are scalar quantized with a uniform logarithmic scalar quantizer with 40 steps of 3dB. The codebook entries of the logarithmic quantizer are shown in Figure 2. As seen in the codebook, the range of the norm factors is $[2^{-2.5}, 2^{17}]$, and the value decreases as the index increases.

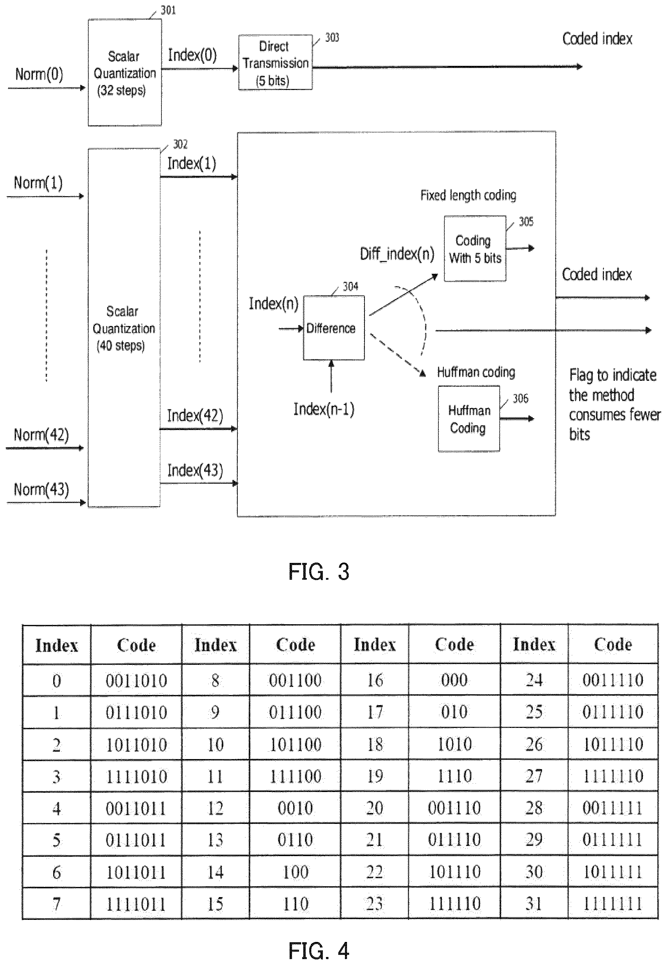

The encoding of quantization indices for norm factors is illustrated in Figure 3. There are in total 44 sub bands and correspondingly, 44 norm factors. For the first sub band, the norm factor is quantized using the first 32 codebook entries (301), while other norm factors are scalar quantized with the 40 codebook entries (302) shown in Figure 2. The quantization index for the first sub band norm factor is directly encoded with 5 bits (303), while the indices for other sub bands are encoded by differential coding. The differential indices are derived using the formula as following (304):

$$Diff\_index(n) = Index(n) - Index(n-1) + 15 \quad for \quad n \in [\,1, 43\,] \quad \dots \quad (\text{Equation 1})$$

And the differential indices are encoded by two possible methods, fixed length coding (305) and Huffman coding (306). The Huffman table for the differential indices is shown in Figure 4. In this table, there are in total 32 entries, from 0 to 31, which caters for possibilities of abrupt energy change between neighboring sub bands.

However, for an audio input signal, there is a physical phenomenon named as auditory masking. Auditory masking occurs when the perception of one sound is affected by the presence of another sound. As example, if there are two signals with similar frequencies existing at the same time: one powerful spike at 1kHz and one lower-level tone at 1.1kHz, the lower-level tone at 1.1kHz will be masked (inaudible) due to existence of the powerful spike at 1kHz.

The sound pressure level needed to make the sound perceptible in the presence of another sound (masker), is defined as masking threshold in audio encoding. The masking threshold depends upon the frequency, the sound pressure level of the masker. If the two sounds have similar frequency, the masking effect is large, and the masking threshold is also large. If the masker has large sound pressure level, it has strong masking effect on the other sound, and the masking threshold is also large.

According to the auditory masking theory above, if one sub band has very large energy, it would have large masking effect on other sub bands, especially on its neighboring sub bands. Then the masking threshold for other sub bands, especially the neighboring sub band, is large.

If the sound component in the neighboring sub band has small quantization errors (less than the masking threshold), the degradation on sound component in this sub band is not able to be perceived by the listeners.

It is not necessary to encode the normal factor with very high resolution for this sub band as long as the quantization errors below the masked threshold.

Solution to Problem

In this invention, apparatus and methods exploring audio signal properties for generating Huffman tables and for selecting Huffman tables from a set of predefined tables during audio signal encoding are provided.

Briefly, the auditory masking properties are explored to narrow down the range of the differential indices, so that a Huffman table which have fewer code words can be designed and used for encoding. As the Huffman table has fewer code words, it is possible to design the code codes with shorter length (consumes fewer bits). By doing this, the total bits consumption to encode the differential indices can be reduced.

Advantageous Effects of Invention

By adopting Huffman codes which consume fewer bits, the total bits consumption to encode the differential indices can be reduced.

Brief Description of Drawings

The present invention is defined by the independent claims which are set out by equations (11) and (13) and the corresponding parts of the description. All other embodiments and drawings are to be interpreted as examples useful for understanding the invention and are not part of the invention.
Figure 1 illustrates the framework of ITU-T G.719;
Figure 2 shows the codebook for norm factors quantization;
Figure 3 illustrates the process of norm factors quantization and coding;
Figure 4 shows the Huffman table used for norm factors indices encoding;
Figure 5 shows the framework which adopts this invention;
Figures 6A and 6B show examples of predefined Huffman tables;
Figure 7 illustrates the derivation of the masking curve;
Figure 8 illustrates how the range of the differential indices be narrowed down;
Figure 9 shows a flowchart of how the modification of the indices is done;
Figure 10 illustrates how the Huffman tables can be designed;
Figure 11 illustrates the framework of embodiment 2 of this invention;
Figure 12 illustrates the framework of embodiment 3 of this invention;
Figure 13 illustrates the encoder of embodiment 4 of this invention;
Figure 14 illustrates the decoder of embodiment 4 of this invention.

Description of Embodiments

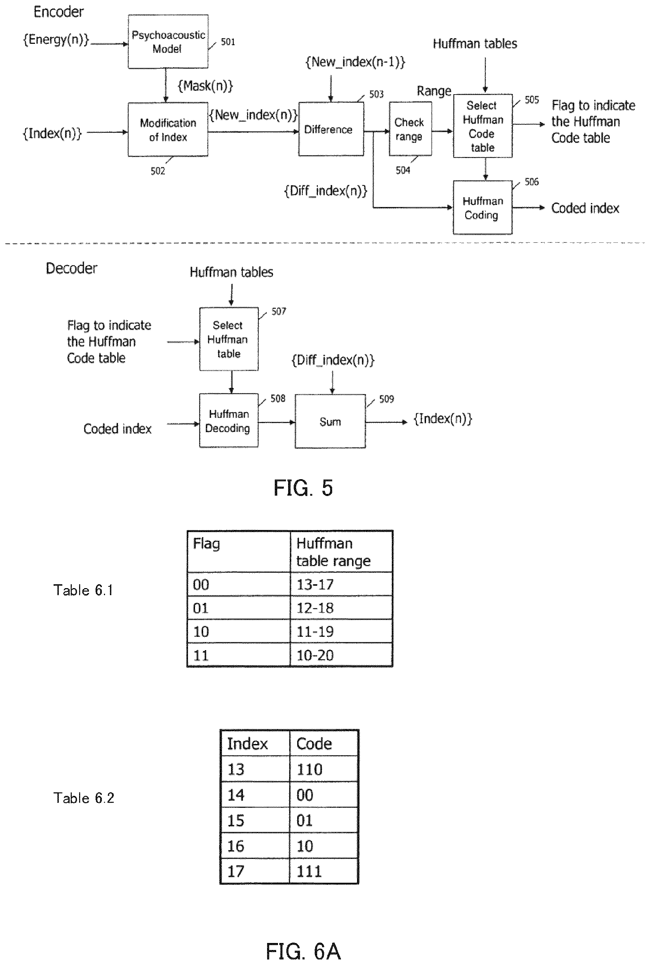

The main principle of the invention is described in this section with the aid of Figure 5 to Figure 12. Those who are skilled in the art will be able to modify and adapt this invention without deviating from the invention. Illustrations are provided to facilitate explanation

(Embodiment 1)

Figure 5 illustrates the invented codec, which comprises an encoder and a decoder that apply the invented scheme on Huffman coding.
In the encoder illustrated in Figure 5, the energies of the sub bands are processed by the psychoacoustic modelling (501) to derive the masking threshold Mask(n). According to the derived Mask(n), the quantization indices of the norm factors for the sub bands whose quantization errors are below the masking threshold are modified (502) so that the range of the differential indices can be smaller.
The differential indices for the modified indices are calculated according to the equation below:

$$Diff\_index(n) = New\_index(n) - New\_index(n-1) + 15$$
$$for \quad n \in [\,1,43\,] \qquad\qquad \ldots \quad (Equation\ 2)$$

The range of the differential indices for Huffman coding is identified as shown in the equation below (504).

$$Range = [Min(Diff\_index(n), Max(Diff\_index(n)))] \qquad \ldots \quad (Equation\ 3)$$

According to the value of the range, the Huffman table which is designed for the specific range among a set of predefined Huffman table is selected (505) for encoding of the differential indices (506). As example, if among all the differential indices for the input frame, the minimum value is 12, and the maximum value is 18, then the Range = [12,18], The Huffman table designed for [12,18] are selected as the Huffman table for encoding.

The set of predefined Huffman tables are designed (detail will be explained in later part) and arranged according to the range of the differential indices. The flag signal to indicate the selected Huffman table and the coded indices are transmitted to the decoder side.

Another method for selection of Huffman table is to calculate all the bits consumption using every Huffman table, then select the Huffman table which consumes fewest bits.

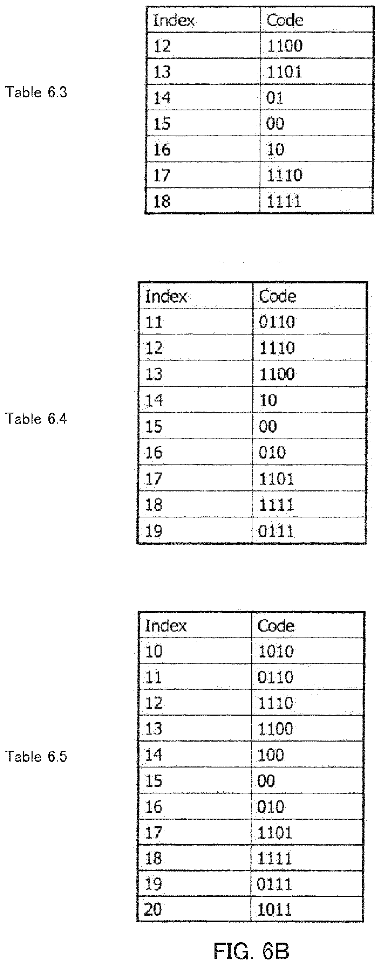

As example, a set of 4 predefined Huffman tables are shown in Figures 6A and 6B. In this example, there are 4 predefined Huffman tables, covered range of [13,17], [12,18],[11,19] and [10,20] correspondingly. Table 6.1 shows the flag signal and corresponding range for Huffman table. Table 6.2 shows the Huffman codes for all the values in the range of [13,17], Table 6.3 shows the Huffman codes for all the values in the range of [12,18]. Table 6.4 shows the Huffman codes for all the values in the range of [11,19]. Table 6.5 shows the Huffman codes for all the values in the range of [10,20],

Comparing the Huffman code length in Figures 6A and 6B with the original Huffman table shown in Figure 4, it can be seen that the Huffman code length for the same values consumes fewer bits. It explains how the bits are saved.

In the decoder illustrated in Figure 5, according to the flag signal, the corresponding Huffman table is selected (507) for decoding of the differential indices (508). The differential indices are used to reconstruct the norm factors quantization indices according to the equation below:

$$Diff\_index(n) = Index(n) + Index(n-1) - 15$$
$$for \quad n \in [\, 1, 43\, ] \qquad\qquad\qquad \dots \quad (Equation\, 4)$$

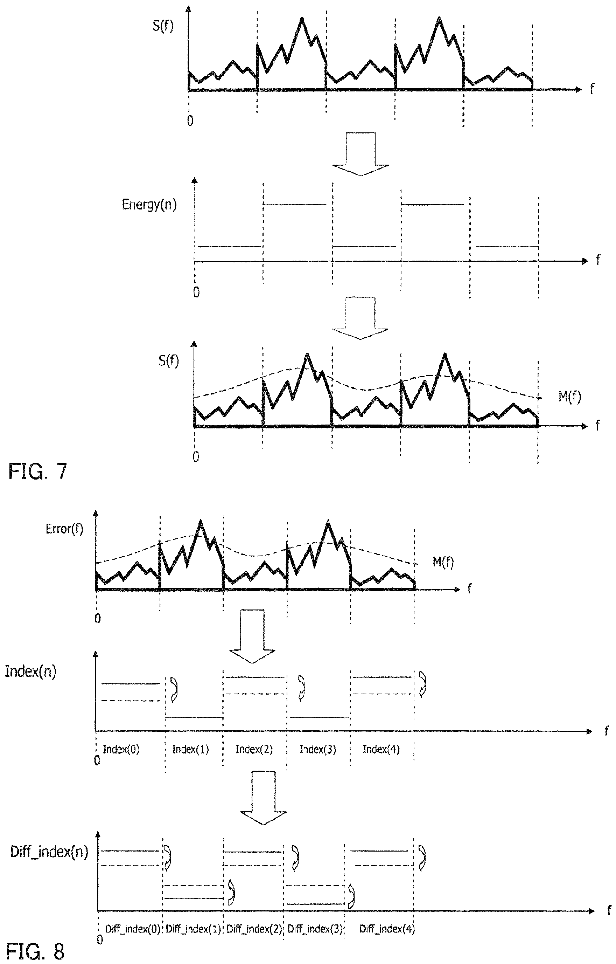

Figure 7 illustrates the derivation of the masking curve of the input signal. Firstly, the energies of the sub bands are calculated, and with these energies and masking curve of the input signal are derived. The masking curve derivation can utilize some prior art existing technologies such as the masking curve derivation method in MPEG AAC codec.

Figure 8 illustrates how the range of the differential indices is narrowed down. Firstly, the comparison is done between the masking threshold and the sub band quantization error energy. For the sub bands whose quantization errors energy are below the masking threshold, their indices are modified to a value which is closer to the neighbouring sub band, but the modification is ensured that the corresponding quantization error energy does not exceed the masking threshold, so that sound quality is not affected. After the modification, the range of the indices can be narrowed down. It is explained as below.

As shown in figure 8, for sub bands 0, 2 and 4, because their quantization error energies are below the masking threshold, their indices are modified to be closer to their neighbouring indices.

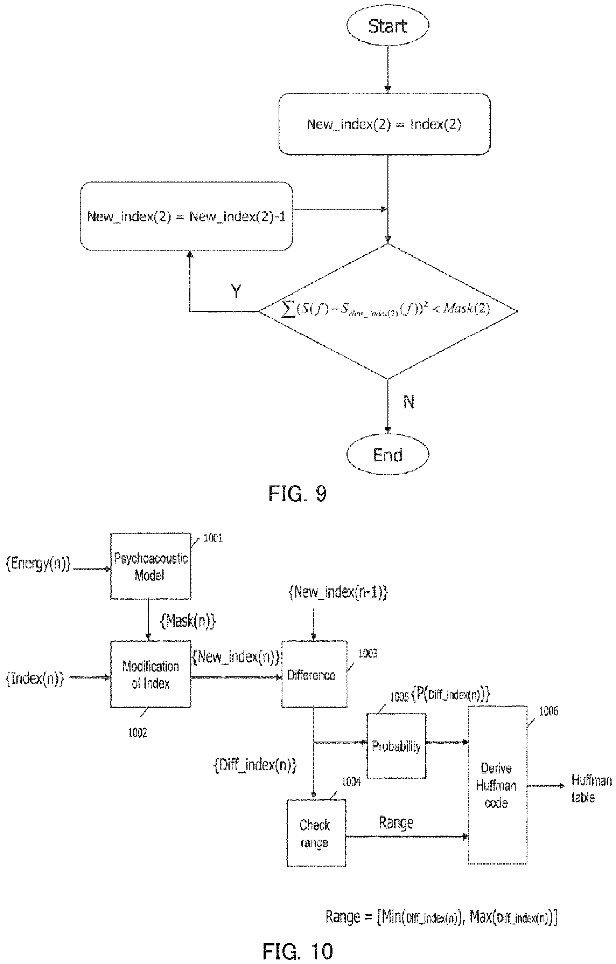

The modification of the indices can be done as below (using sub band 2 as example). As shown in Figure 2, large index is corresponding to smaller energy, and then Index(1) is smaller than Index(2). The modification of Index(2) is actually to decrease its value. It can be done as shown in Figure 9.

For sub bands 1 and 3, because their energies are above the masking threshold, their indices are not changed. Then the differential indices are closer to the centre. Using sub band 1 as example:

[5]

$$Diff\_index(1) = Index(1) - Index(0) + 15 \quad for \quad n \in [\, 1, 43\, ] \qquad \dots \quad (Equation\, 5)$$

[6]

$$New\_diff\_index(1) = New\_index(1) - New\_index(0) + 15 \qquad \dots \quad (Equation\, 6)$$
$$for \quad n \in [\, 1, 43\, ]$$

[7]

$$\because New\_index(1) - New\_index(0) < Index(1) - Index(0)$$
$$\therefore New\_diff\_index(1) - 15 < Diff\_index(1) - 15 \qquad\qquad \dots \quad (Equation\, 7)$$

In this invention, the design of the Huffman table can be done offline with a large input sequence database. The process is illustrated in Figure 10.

The energies of the sub bands processed by the psychoacoustic modelling (1001) to derive the masked threshold Mask(n). According to the derived Mask(n), the quantization indices of the norm factors for the sub bands whose quantization errors energy are below the masking threshold are modified (1002) so that the range of the differential indices can be smaller.

The differential indices for the modified indices are calculated (1003).

The range of the differential indices for Huffman coding is identified (1004). For each value of range, all the input signal which have the same range will be gathered and the probability distribution of each value of the differential index within the range is calculated.

For each value of range, one Huffman table is designed according to the probability. Some traditional Huffman table design methods can be used here to design the Huffman table.

(Embodiment 2)

In this embodiment, a method which can maintain the bits saving, but to restore the differential indices to a value closer to the original value is introduced.

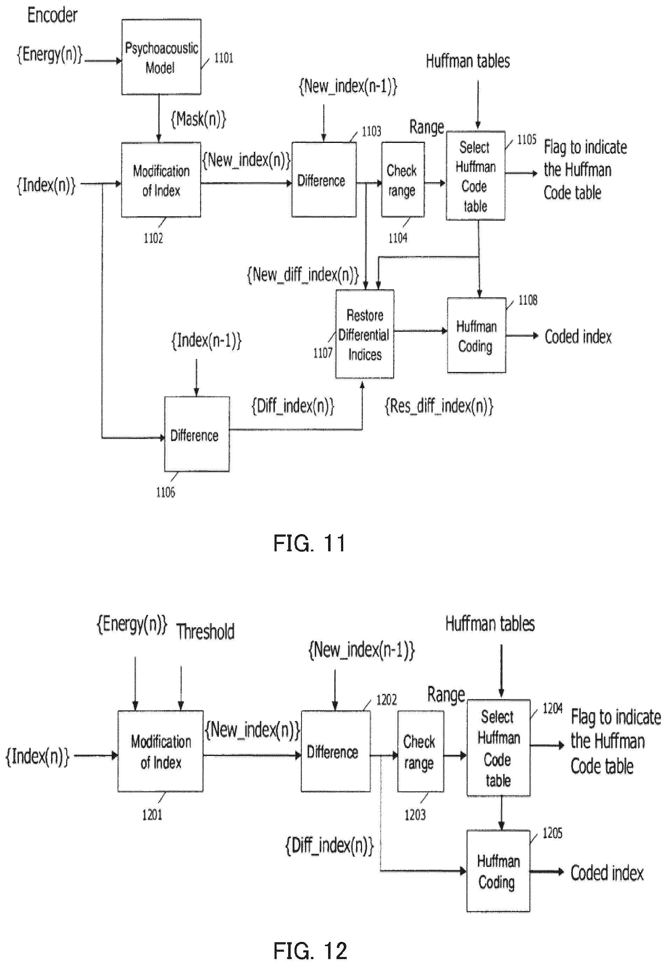

As shown in figure 11, after the Huffman table is selected in 1105, the differential indices are calculated between the original quantization indices. The original differential indices and new differential indices are compared whether they consume same bits in the selected Huffman table.

If they consume same number of bits in the selected Huffman table, the modified differential indices are restored to the original differential indices. If they don't consume same number of bits, the code words in the Huffman table which is closest to the original differential indices and consumes same number of bits are selected as the restored differential indices.

The merits of this embodiment are quantization error of the norm factor can be smaller while the bits consumption is the same as the embodiment 1.

(Embodiment 3)

In this embodiment, a method which avoids using of the psychoacoustic model but only use some energy ratio threshold is introduced.

As shown in figure 12, instead of using the psychoacoustic model to derive the masking threshold. The energies of the sub bands and a predefined energy ratio threshold are used to determine whether to modify the quantization index of the specific sub band (1201). As shown in the equation below, if the energy ratio between current sub band and neighbouring sub band is less than threshold, then current sub band is considered as not so important, then the quantization index of the current sub band can be modified.

$$Energy(n) / Energy(n-1) \quad < Threshold$$
$$\&\& \quad Energy(n) / Energy(n+1) \quad < Threshold \qquad \dots \quad (Equation\ 8)$$

The modification of the quantization index can be done as shown in the equation below:

$$(\frac{NF_{New\_index(n)}}{NF_{Index(n)}})^2 \quad = Min(Energy(n-1), Energy(n+1)) * Threshold / Energy(n)$$

$$\Rightarrow NF_{New\_index(n)} \quad = \sqrt{Min(Energy(n-1), Energy(n+1)) * Threshold / Energy(n)} * NF_{Index(n)}$$

$$\dots \quad (Equation\ 9)$$

where,

$NF_{New\_index(n)}$ means the decoded norm factor for sub band n using modified quantization index
$NF_{Index(n)}$ means the decoded norm factor for sub band n using the original quantization index
$Energy(n-1)$ means the energy for sub band n -1
$Energy(n)$ means the energy for sub band n
$Energy(n+1)$ means the energy for sub band n + 1

The merit of this embodiment is the very complex and high complexity psychoacoustic modelling can be avoided.

(Embodiment 4)

In this embodiment, a method which narrows down the range of the differential indices while being able to perfectly reconstruct the differential indices is introduced.

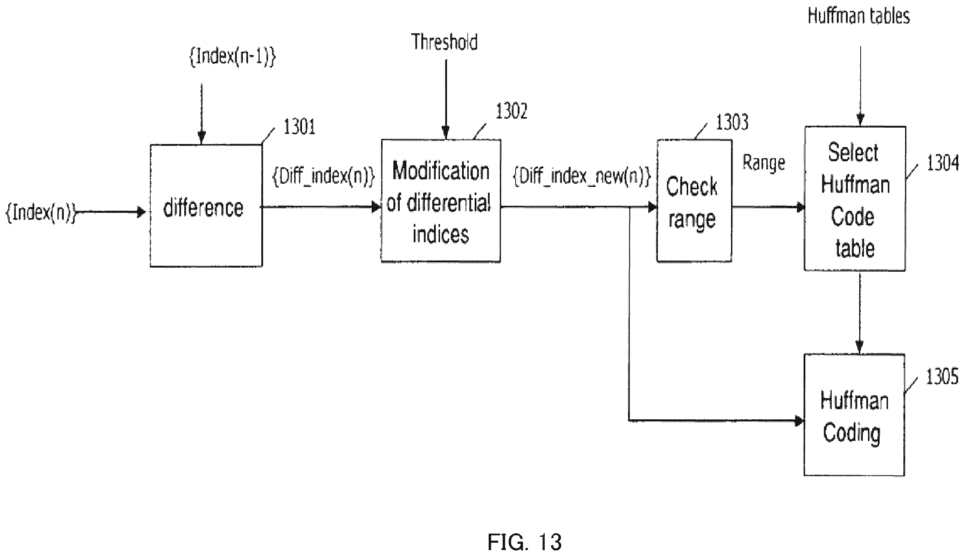

As shown in figure 13, the differential indices are derived from the original quantization indices (1301) according to the equation below:

$$Diff\_index(\mathrm{n}) = Index(\mathrm{n}) - Index(\mathrm{n}-1) + 15 \quad \ldots \quad (\text{Equation } 10)$$

where,

Diff_index($n$) means differential index for sub band n
Index($n$) means the quantization index for sub band n
Index($n$ -1) means the quantization index for sub band n -1

In order to reduce the range of the differential indices, a module is implemented to modify values of some differential indices (1302).

The modification is done according to the value of the differential index for the preceding sub band and a threshold.

One way to modify the differential index (when n ≥ 1) can be done as shown in the equation below, the first differential index would not be modified so as to achieve perfect reconstruction in decoder side:

if $Diff\_index$ (n -1) > (15 + $Threshold$ ),

$$Diff\_inde\,x\_new\,(\mathrm{n}) = Diff\_index\,(\mathrm{n}) + Diff\_index\,(\mathrm{n}-1) - (15 + Threshold\,);$$

else if $Diff\_index$ (n -1) < 15 - $Threshold$ ),

$$Diff\_index\_new\,(\mathrm{n}) = Diff\_index\,(\mathrm{n}) + Diff\_index\,(\mathrm{n}-1) - (15 - Threshold\,);$$

otherwise

$$Diff\_inde\,x\_new\,(\mathrm{n}) = Diff\_index\,(\mathrm{n})\,; \qquad\qquad \ldots \quad (\text{Equation } 11)$$

where,

n ≥ 1;
Diff_index (n) means differential index for sub band n;
Diff_index (n -1) means differential index for sub band n -1;
Diff_index _new(n) means the new differential index for sub band n;
Threshold means the value to examine whether to make the modification of the differential index;

The reason why this modification can reduce the range of the differential indices is explained as following: for audio/speech signal, it is true that the energy fluctuates from one frequency band to another frequency band. However, it is observed that, there is normally no abrupt change in energy from neighboring frequency bands. The energy gradually increases or decreases from one frequency band to another frequency band. The norm factors which represent the energy also gradually changes. The norm factor quantization indices would also gradually change, and then the differential indices would vary in a small range.

The abrupt energy change happens only when some main sound components which have large energy start to show effect in the frequency band or their effect start to diminish. The norm factors which represent the energy also have abrupt change from the preceding frequency band, the norm factor quantization indices would also suddenly increase or decrease by a large value. Then it resulted in a very large or very small differential index.

As an example, assume that there is one main sound component which has large energy in frequency sub band n. While in frequency sub band (n-1) and (n+1), there is no main sound component. Then according to the Huffman table in Figure 2, Index (n) will have very small value, while Index (n-1) and Index (n+1) will have very large value. Then according to Equation (10), Diff_index(n) is very small (less than (15-Threshold)) and Diff_index(n+1) is very large. If the modification in Equation (11) is conducted, then according to Equation (12) below, the upper boundary of the differential indices can be possibly reduced, therefore the range of the differential indices can be narrowed down.

$$\because Diff\_index\_new\,(n-1) < (15 - Threshold)$$
$$\therefore Diff\_index(n-1) - (15 - Threshold) < 0$$
$$\because Diff\_index\_new\,(n) = Diff\_index(n) + Diff\_index(n-1) - (15 - Threshold);$$
$$\therefore Diff\_index\_new\,(n) < Diff\_index(n) \qquad\qquad \dots \quad (Equation\,12)$$

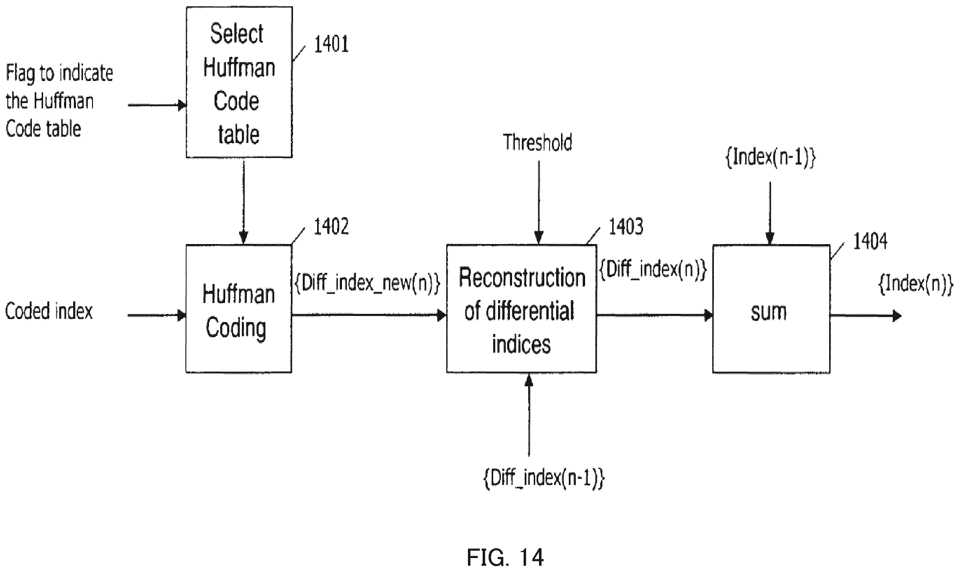

As shown in Figure 14, in decoder side, in order to perfectly reconstruct the differential indices, one module named as 'reconstruction of differential indices' (1403) is implemented. The reconstruction is done according to the value of the differential index for the preceding sub band and a threshold. The threshold in decoder is same as the threshold used in encoder.

The way to reconstruct the differential index(when $n \geq 1$), which is corresponding to the modification in encoder, can be done as shown in the equation below, the first differential index would be directly received as it is not modified at encoder side:

if $Diff\_index(n-1) > (15 + Threshold)$,

$$Diff\_index\,(n) = Diff\_index\_new(n) - Diff\_index(n-1) + (15 + Threshold);$$

else if $Diff\_index(n-1) < 15 - Threshold)$,

$$Diff\_index\,(n) = Diff\_index\_new(n) - Diff\_index(n-1) + (15 - Threshold);$$

otherwise

$$Diff\_index(n) = Diff\_index\_new(n); \qquad\qquad \dots \quad (Equation\,13)$$

where,

$n \geq 1$;
$Diff\_index(n)$ means differential index for sub band n;
$Diff\_index(n-1)$ means differential index for sub band n-1;
$Diff\_index\_new(n)$ means the new differential index for sub band n;
$Threshold$ means the value to examine whether to reconstruct the differential index;

As shown in the above Equation (11) and Equation (13), whether the modification of a differential index should be done and how much it should be modified is all dependent on the differential index for preceding frequency band. If the differential index for the preceding frequency band can be perfectly reconstructed, then the current differential index can also be perfectly reconstructed.

As shown in the above Equation (11) and Equation (13), the first differential index is not modified at encoder side, it is directly received and can be perfectly reconstructed, then the second differential index can be reconstructed according to the value of the first differential index; then the third differential index, the forth differential index, and so on, by following the same procedure, all the differential indices can be perfectly reconstructed.

The merit of this embodiment is that the range of the differential indices can be reduced, while the differential indices can still be perfectly reconstructed in decoder side. Therefore, the bits efficiency can be improved while retain the bit exactness of the quantization indices.

Further, although cases have been described with the embodiments above where the present invention is configured by hardware, the present invention may be implemented by software in combination with hardware.

Each function block employed in the description of the aforementioned embodiment may typically be implemented as an LSI constituted by an integrated circuit. These may be individual chips or partially or entirely contained on a single chip. "LSI" is adopted here but this may also be referred to as "IC," "system LSI," "super LSI" or "ultra LSI" depending on differing extents of integration.

Further, the method of circuit integration is not limited to LSI's, and implementation using dedicated circuitry or general purpose processors is also possible. After LSI manufacture, utilization of an FPGA (Field Programmable Gate Array) or a reconfigurable processor where connections and settings of circuit cells within an LSI can be reconfigured is also possible.

Further, if integrated circuit technology comes out to replace LSI's as a result of the advancement of semiconductor technology or a derivative other technology, it is naturally also possible to carry out function block integration using this technology. Application of biotechnology is also possible.

Industrial Applicability

The encoding apparatus, decoding apparatus and encoding and decoding methods according to the present invention are applicable to a wireless communication terminal apparatus, base station apparatus in a mobile communication system, tele-conference terminal apparatus, video conference terminal apparatus and voice over internet protocol (VOIP) terminal apparatus.

Reference Notations List

| | |
|---|---|
| 101 | Transient detector |
| 102 | Transform |
| 103 | Norm estimation |
| 104 | Norm quantization and coding |
| 105 | Spectrum normalization |
| 106 | Norm adjustment |
| 107 | Bit allocation |
| 108 | Lattice quantization and coding |
| 109 | Noise level adjustment |
| 110 | Multiplex |
| 111 | Demultiplex |
| 112 | Lattice decoding |
| 113 | Spectral fill generator |
| 114 | Envelope shaping |
| 115 | Inverse transform |
| 301 | Scalar Quantization (32 steps) |
| 302 | Scalar Quantization (40 steps) |
| 303 | Direct Transmission (5 bits) |
| 304 | Difference |
| 305 | Fixed length coding |
| 306 | Huffman coding |
| 501 | Psychoacoustic model |
| 502 | Modification of index |
| 503 | Difference |
| 504 | Check range |
| 505 | Select Huffman code table |
| 506 | Huffman coding |
| 507 | Select Huffman table |
| 508 | Huffman decoding |
| 509 | Sum |
| 1001 | Psychoacoustic model |
| 1002 | Modification of index |
| 1003 | Difference |
| 1004 | Check range |
| 1005 | Probability |
| 1006 | Derive Huffman code |

| 1101 | Psychoacoustic model |
|---|---|
| 1102 | Modification of index |
| 1103 | Difference |
| 1104 | Check range |
| 1105 | Select Huffman code table |
| 1106 | Difference |
| 1107 | Restore differential indices |
| 1108 | Huffman coding |
| 1201 | Modification of index |
| 1202 | Difference |
| 1203 | Check range |
| 1204 | Select Huffman code table |
| 1205 | Huffman coding |
| 1301 | Difference |
| 1302 | Modification of differential indices |
| 1303 | Check range |
| 1304 | Select Huffman code table |
| 1305 | Huffman coding |
| 1401 | Select Huffman code table |
| 1402 | Huffman coding |
| 1403 | Reconstruction of differential indices |
| 1404 | Sum |

**Claims**

1. An audio/speech encoding apparatus, comprising:

    a processor;
    a memory;
    a transformer adapted to transform a time domain input audio/speech signal to a frequency spectrum;
    a band divider adapted to divide the frequency spectrum to a plural of bands;
    an norm factor calculator adapted to calculate a level of norm factors for each band;
    a quantizer adapted to quantize the norm factors for the each band;
    a differential index calculator (1301) adapted to calculate differential indices between an Nth band index and an (N-1)th band index, where N is an integer of 1 or more;
    a differential index modifier (1302) adapted to modify a range of the differential indices for the Nth band when N is an integer of 2 or more, and replace the differential index with the modified differential index and adapted not to modify the range of the differential indices for the Nth band when N is an integer of 1;
    a Huffman encoder (1304; 1305) adapted to encode the differential indices using a selected Huffman table; and
    a transmitter adapted to transmit the encoded differential indices and a flag signal for indicating the selected Huffman table to an audio/speech decoding apparatus,
    **characterized in that** when the calculated differential index of the (N-1)th band is greater than a first value, the differential index modifier is adapted to modify a differential index for an Nth band by adding a subtracted value determined by subtracting the first value from a differential index for an (N-1)th band,
    wherein when the calculated differential index of a (N-1)th band is smaller than a second value, the differential index modifier is adapted to modify a differential index for a Nth band by adding a subtracted value determined by subtracting the second value from a differential index for the (N-1)th band,
    wherein the first value is a sum of an offset value and a threshold value, and the second value is a difference of the offset value and the threshold value, and the offset value is 15,
    wherein when the calculated differential index of an (N-1)th band is not greater than the first value and is not smaller than the second value, the differential index modifier is adapted not to modify a differential index for the Nth band, and
    wherein the threshold is the same as the threshold used in a decoding apparatus.

2. An audio/speech decoding apparatus, comprising:

    a receiver for receiving encoded audio/speech signals transmitted from an audio/speech encoding apparatus;

a processor;

a memory;

a Huffman table selector (1401) adapted to select a Huffman table according to a flag signal to indicate the Huffman table selected by the audio/speech encoding apparatus;

a Huffman decoder (1402) adapted to decode differential indices between an Nth band index and an (N-1)th band index, where N is an integer of 1 or more, received by the audio/speech encoding apparatus, using the selected Huffman table;

a differential indices reconstructor (1403) adapted to reconstruct an Nth different index decoded using the selected Huffman table when N is an integer of 2 or more, and replaces the differential index with the reconstructed differential index, and adapted not to reconstruct the Nth differential index when N is an integer of 1;

an index calculator (1404) adapted to calculate quantization indices using the reconstructed differential indices;

a dequantizer adapted to dequantize a level of norm factors for each band; and

a transformer adapted to transform a decoded spectrum which is generated using the norm factor for each band in a frequency domain to a time domain signal,

**characterized in that** when the decoded differential index of the (N-1)th band is greater than a first value, the differential indices reconstructor is adapted to reconstruct a differential index for an Nth band by subtracting a subtracted value determined by subtracting the first value from a differential index for an (N-1)th band,

wherein when the decoded differential index of an (N-1)th band is smaller than a second value, the differential indices reconstructor is adapted to reconstruct a differential index for an Nth band by subtracting a subtracted value determined by subtracting the second value from a differential index for the (N-1)th band,

wherein the first value is a sum of an offset value and a threshold value, and the second value is a difference of the offset value and the threshold value, and the offset value is 15, wherein when the decoded differential index of an (N-1)th band is not greater than the first value and is not smaller than the second value, the differential indices reconstructor is adapted to reconstruct a decoded differential index for the Nth band, and

wherein the threshold is the same as the threshold used in an encoding apparatus.

3. An audio/speech encoding method, comprising:

transforming, by a transformer, a time domain input audio/speech signal to a frequency spectrum dividing the frequency spectrum to a plural of bands;

calculating a level of norm factors for each band;

quantizing the norm factors for the each band;

calculating differential indices between an Nth band index and an (N-1)th band index, where N is an integer of 1 or more;

modifying a range of the differential indices for the Nth band when N is an integer of 2 or more, and replacing the differential index with the modified differential index and not modifying the range of the differential indices for the Nth band when N is an integer of 1;

encoding the differential indices using a selected Huffman table; and

transmitting the encoded differential indices and a flag signal for indicating the selected Huffman table to an audio/speech decoding apparatus,

**characterized in that** when the calculated differential index of the (N-1)th band is greater than a first value, a differential index for an Nth band is modified by adding a subtracted value determined by subtracting the first value from a differential index for an (N-1)th band,

wherein when the calculated differential index of an (N-1)th band is smaller than a second value, a differential index for an Nth band is modified by adding a subtracted value determined by subtracting the second value from a differential index for the (N-1)th band, wherein the first value is a sum of an offset value and a threshold value, and the second value is a difference of the offset value and the threshold value, and the offset value is 15, wherein when the calculated differential index of an (N-1)th band is not greater than the first value and is not smaller than the second value, the differential index for the Nth band is not modified, and

wherein the threshold is the same as the threshold used in a decoding apparatus.

4. An audio/speech decoding method, comprising:

receiving encoded audio/speech signals transmitted from an audio/speech encoding apparatus;

selecting a Huffman table according to a flag signal to indicate the selected Huffman table by the audio/speech encoding apparatus;

decoding differential indices between an Nth band index and an (N-1)th band index, where N is an integer of 1 or more, received by the audio/speech encoding apparatus, using the selected Huffman table;

reconstructing an Nth different index decoded using the selected Huffman table when N is an integer of 2 or more, and replacing the differential index with the reconstructed differential index, and not reconstructing the Nth differential index when N is an integer of 1;

calculating quantization indices using the reconstructed differential indices;

dequantizing, by a dequantizer, a level of norm factors for each band; and

transforming a decoded spectrum which is generated using the norm factors for each band in a frequency domain to a time domain signal,

**characterized in that** when the differential index of the (N-1)th band is greater than a first value, a differential index for an Nth band is reconstructed by subtracting a subtracted value determined by subtracting the first value from a differential index for an (N-1)th band, wherein when the decoded differential index of an (N-1)th band is smaller than a second value, a differential index for an Nth band is reconstructed by subtracting a subtracted value determined by subtracting the second value from a differential index for the (N-1)th band, wherein the first value is a sum of an offset value and a threshold value, and the second value is a difference of the offset value and the threshold value, and the offset value is 15, wherein when the decoded differential index of an (N-1)th band is not greater than the first value and is not smaller than the second value, a decoded differential index for the Nth band is reconstructed, and

wherein the threshold is the same as the threshold used in an encoding apparatus.

**Patentansprüche**

1. Audio/Sprache-Codiervorrichtung, umfassend:

   einen Prozessor,

   einen Speicher,

   einen Wandler, der ausgebildet ist zum Wandeln eines in der Zeitdomäne eingegebenen Audio-/Sprachsignals zu einem Frequenzspektrum,

   einen Bandteiler, der ausgebildet ist zum Teilen des Frequenzspektrums in eine Vielzahl von Bändern,

   einen Normfaktor-Berechner, der ausgebildet ist zum Berechnen eines Pegels von Normfaktoren für jedes Band,

   einen Quantisierer, der ausgebildet ist zum Quantisieren der Normfaktoren für jedes Band,

   einen Differenzindex-Berechner (1301), der ausgebildet ist zum Berechnen von Differenzindizes zwischen einem N-ten Bandindex und einem (N-1)-ten Bandindex, wobei N eine Ganzzahl von 1 oder größer ist,

   einen Differenzindex-Modifizierer (1302), der ausgebildet ist zum Modifizieren eines Bereichs der Differenzindizes für das N-te Band, wenn N eine Ganzzahl von 2 oder größer ist, und zum Ersetzen des Differenzindex durch den modifizierten Differenzindex und ausgebildet ist zum nicht-Modifizieren des Bereichs der Differenzindizes für das N-te Band, wenn N eine Ganzzahl von 1 ist,

   einen Huffman-Codierer (1304; 1305), der ausgebildet ist zum Codieren der Differenzindizes unter Verwendung einer ausgewählten Huffman-Tabelle, und

   einen Sender, der ausgebildet ist zum Senden der codierten Differenzindizes und eines Flag-Signals für das Angeben der ausgewählten Huffman-Tabelle zu einer Audio/Sprache-Decodiervorrichtung,

   **dadurch gekennzeichnet, dass**:

   wenn der berechnete Differenzindex des (N-1)-ten Bands größer als ein erster Wert ist, der Differenzindex-Modifizierer ausgebildet ist zum Modifizieren eines Differenzindex für ein N-tes Band durch das Addieren eines subtrahierten Werts, der durch das Subtrahieren des ersten Werts von einem Differenzindex für ein (N-1)-tes Band bestimmt wird,

   wenn der berechnete Differenzindex eines (N-1)-ten Bands kleiner als ein zweiter Wert ist, der Differenzindex-Modifizierer ausgebildet ist zum Modifizieren eines Differenzindex für ein N-tes Band durch das Addieren eines subtrahierten Werts, der durch das Subtrahieren des zweiten Werts von einem Differenzindex für das (N-1)-te Band erhalten wird,

   der erste Wert eine Summe aus einem Versatzwert und einem Schwellwert ist und der zweite Wert eine Differenz zwischen dem Versatzwert und dem Schwellwert ist, wobei der Versatzwert gleich 15 ist,

   wenn der berechnete Differenzindex eines (N-1)-ten Bands nicht größer als der erste Wert ist und nicht kleiner als der zweite Wert ist, der Differenzindex-Modifizierer ausgebildet ist zum nicht-Modifizieren eines Differenzindex für das N-te Band, und

   der Schwellwert gleich dem in einer Decodiervorrichtung verwendeten Schwellwert ist.

2. Audio/Sprache-Decodiervorrichtung, umfassend:

einen Empfänger zum Empfangen von codierten Audio-/Sprachsignalen, die von einer Audio/Sprache-Codiervorrichtung gesendet werden,

einen Prozessor,

einen Speicher,

einen Huffman-Tabelle-Auswähler (1401), der ausgebildet ist zum Auswählen einer Huffman-Tabelle gemäß einem Flag-Signal, um eine durch die Audio/Sprache-Codiervorrichtung ausgewählte Huffman-Tabelle anzugeben,

einen Huffman-Decodierer (1402), der ausgebildet ist zum Decodieren von Differenzindizes zwischen einem N-ten Bandindex und einem (N-1)-ten Bandindex, wobei N eine Ganzzahl von 1 oder größer ist, die durch die Audio/Sprache-Codiervorrichtung empfangen werden, unter Verwendung der ausgewählten Huffman-Tabelle,

einen Differenzindizes-Wiederhersteller (1403), der ausgebildet ist zum Wiederherstellen eines N-ten Differenzindex, der unter Verwendung der ausgewählten Huffman-Tabelle decodiert wird, wenn N eine Ganzzahl von 2 oder größer ist, und den Differenzindex durch den wiederhergestellten Differenzindex ersetzt, und ausgebildet ist zum nicht-Wiederherstellen des N-ten Differenzindex, wenn N eine Ganzzahl von 1 ist,

einen Indexberechner (1404), der ausgebildet ist zum Berechnen von Quantisierungsindizes unter Verwendung der wiederhergestellten Differenzindizes,

einen Dequantisierer, der ausgebildet ist zum Dequantisieren eines Pegels von Normfaktoren für jedes Band, und

einen Wandler, der ausgebildet ist zum Wandeln eines decodierten Spektrums, das unter Verwendung des Normfaktors für jedes Band in einer Frequenzdomäne erzeugt wird, zu einem Zeitdomänensignal,

**dadurch gekennzeichnet, dass**:

wenn der decodierte Differenzindex des (N-1)-ten Bands größer als ein erster Wert ist, der Differenzindizes-Widerhersteller ausgebildet ist zum Wiederherstellen eines Differenzindex für ein N-tes Band durch das Subtrahieren eines subtrahierten Werts, der durch das Subtrahieren des ersten Werts von einem Differenzindex für ein (N-1)-tes Band bestimmt wird,

wenn der decodierte Differenzindex eines (N-1)-ten Bands kleiner als ein zweiter Wert ist, der Differenzindizes-Wiederhersteller ausgebildet ist zum Wiederherstellen eines Differenzindex für ein N-tes Band durch das Subtrahieren eines subtrahierten Werts, der durch das Subtrahieren des zweiten Werts von einem Differenzindex für das (N-1)-te Band erhalten wird,

der erste Wert eine Summe aus einem Versatzwert und einem Schwellwert ist und der zweite Wert eine Differenz zwischen dem Versatzwert und dem Schwellwert ist, wobei der Versatzwert gleich 15 ist,

wenn der decodierte Differenzindex eines (N-1)-ten Bands nicht größer als der erste Wert ist und nicht kleiner als der zweite Wert ist, der Differenzindizes-Wiederhersteller ausgebildet ist zum Wiederherstellen eines decodierten Differenzindex für das N-te Band, und

der Schwellwert gleich dem in einer Codiervorrichtung verwendeten Schwellwert ist.

3. Audio/Sprache-Codierverfahren, umfassend:

Wandeln, durch einen Wandler, eines in der Zeitdomäne eingegebenen Audio-/Sprachsignals zu einem Frequenzspektrum,

Teilen des Frequenzspektrums in eine Vielzahl von Bändern,

Berechnen eines Pegels von Normfaktoren für jedes Band,

Quantisieren der Normfaktoren für jedes Band,

Berechnen von Differenzindizes zwischen einem N-ten Bandindex und einem (N-1)-ten Bandindex, wobei N eine Ganzzahl von 1 oder größer ist,

Modifizieren eines Bereichs der Differenzindizes für das N-te Band, wenn N eine Ganzzahl von 2 oder größer ist, und Ersetzen des Differenzindex durch den modifizierten Differenzindex und nicht-Modifizieren des Bereichs der Differenzindizes für das N-te Band, wenn N eine Ganzzahl von 1 ist,

Codieren der Differenzindizes unter Verwendung einer ausgewählten Huffman-Tabelle, und

Senden der codierten Differenzindizes und eines Flag-Signals für das Angeben der ausgewählten Huffman-Tabelle zu einer Audio/Sprache-Decodiervorrichtung,

**dadurch gekennzeichnet, dass**:

wenn der berechnete Differenzindex des (N-1)-ten Bands größer als ein erster Wert ist, ein Differenzindex für ein N-tes Band durch das Addieren eines subtrahierten Werts, der durch das Subtrahieren des ersten Werts von einem Differenzindex für ein (N-1)-tes Band bestimmt wird, modifiziert wird,

wenn der berechnete Differenzindex eines (N-1)-ten Bands kleiner als ein zweiter Wert ist, ein Differenzindex für ein N-tes Band durch das Addieren eines subtrahierten Werts, der durch das Subtrahieren des zweiten Werts von einem Differenzindex für das (N-1)-te Band erhalten wird, modifiziert wird,
der erste Wert eine Summe aus einem Versatzwert und einem Schwellwert ist und der zweite Wert eine Differenz zwischen dem Versatzwert und dem Schwellwert ist, wobei der Versatzwert gleich 15 ist,
wenn der berechnete Differenzindex eines (N-1)-ten Bands nicht größer als der erste Wert ist und nicht kleiner als der zweite Wert ist, der Differenzindex für das N-te Band nicht modifiziert wird, und
der Schwellwert gleich dem in einer Decodiervorrichtung verwendeten Schwellwert ist.

4. Audio/Sprache-Decodierverfahren, umfassend:

Empfangen von codierten Audio-/Sprachsignalen, die von einer Audio/Sprache-Codiervorrichtung gesendet werden,
Auswählen einer Huffman-Tabelle gemäß einem Flag-Signal, um eine durch die Audio/Sprache-Codiervorrichtung ausgewählte Huffman-Tabelle anzugeben,
Decodieren von Differenzindizes zwischen einem N-ten Bandindex und einem (N-1)-ten Bandindex, wobei N eine Ganzzahl von 1 oder größer ist, die durch die Audio/Sprache-Codiervorrichtung empfangen werden, unter Verwendung der ausgewählten Huffman-Tabelle,
Wiederherstellen eines N-ten Differenzindex, der unter Verwendung der ausgewählten Huffman-Tabelle decodiert wird, wenn N eine Ganzzahl von 2 oder größer ist, und Ersetzen des Differenzindex durch den wiederhergestellten Differenzindex, und nicht-Wiederherstellen des N-ten Differenzindex, wenn N eine Ganzzahl von 1 ist,
Berechnen von Quantisierungsindizes unter Verwendung der wiederhergestellten Differenzindizes,
Dequantisieren, durch einen Dequantisierer, eines Pegels von Normfaktoren für jedes Band, und
Wandeln eines decodierten Spektrums, das unter Verwendung der Normfaktoren für jedes Band in einer Frequenzdomäne erzeugt wird, zu einem Zeitdomänensignal,
**dadurch gekennzeichnet, dass**:

wenn der Differenzindex des (N-1)-ten Bands größer als ein erster Wert ist, ein Differenzindex für ein N-tes Band durch das Subtrahieren eines subtrahierten Werts, der durch das Subtrahieren des ersten Werts von einem Differenzindex für ein (N-1)-tes Band bestimmt wird, wiederhergestellt wird,
wenn der decodierte Differenzindex eines (N-1)-ten Bands kleiner als ein zweiter Wert ist, ein Differenzindex für ein N-tes Band durch das Subtrahieren eines subtrahierten Werts, der durch das Subtrahieren des zweiten Werts von einem Differenzindex für das (N-1)-te Band erhalten wird, wiederhergestellt wird
der erste Wert eine Summe aus einem Versatzwert und einem Schwellwert ist und der zweite Wert eine Differenz zwischen dem Versatzwert und dem Schwellwert ist, wobei der Versatzwert gleich 15 ist,
wenn der decodierte Differenzindex eines (N-1)-ten Bands nicht größer als der erste Wert ist und nicht kleiner als der zweite Wert ist, ein decodierter Differenzindex für das N-te Band wiederhergestellt wird, und
der Schwellwert gleich dem in einer Codiervorrichtung verwendeten Schwellwert ist.

## Revendications

1. Appareil de codage audio/vocal comprenant :

un processeur ;
une mémoire ;
un transformateur conçu pour la transformation d'un signal d'entrée audio/vocal dans le domaine temporel en un spectre de fréquences ;
un diviseur de bande conçu pour diviser le spectre de fréquences en plusieurs bandes ;
un calculateur de facteurs normatifs conçu pour le calcul d'un niveau de facteurs normatifs pour chaque bande ;
un quantificateur conçu pour quantifier les facteurs de norme pour chaque bande ;
un calculateur d'indices différentiels (1301) conçu pour calculer les indices différentiels entre un Nième indice de bande et un (N-1)ième indice de bande, où N est un nombre entier de 1 ou plus ;
un modificateur d'indice différentiel (1302) conçu pour modifier une gamme d'indices différentiels pour la Nième bande lorsque N est un entier de 2 ou plus, et remplacer l'indice différentiel par l'indice différentiel modifié, et conçu pour ne pas modifier la gamme d'indices différentiels pour la Nième bande lorsque N est un entier de 1 ;
un codeur de Huffman (1304 ; 1305) conçu pour coder les indices différentiels à l'aide d'une table de Huffman sélectionnée ; et
un émetteur conçu pour transmettre les indices différentiels codés et un signal de drapeau pour indiquer la table de Huffman sélectionnée à un appareil de décodage audio/parole,

**caractérisé par le fait que**

lorsque l'indice différentiel calculé de la (N-1)ième bande est supérieur à une première valeur, le modificateur d'indice différentiel est conçu pour modifier un indice différentiel pour une Nième bande en ajoutant une valeur soustraite déterminée en soustrayant la première valeur d'un indice différentiel pour une (N-1)ième bande,

lorsque l'indice différentiel calculé d'une (N-1)ième bande est inférieur à une seconde valeur, le modificateur d'indice différentiel est conçu pour modifier l'indice différentiel d'une Nième bande en ajoutant une valeur soustraite déterminée en soustrayant la seconde valeur de l'indice différentiel de la (N-1)ième bande,

la première valeur est la somme d'une valeur de décalage et d'une valeur de seuil, la seconde valeur est la différence entre la valeur de décalage et la valeur de seuil, et la valeur de décalage est de 15,

dans lequel, lorsque l'indice différentiel calculé d'une (N-1)ième bande n'est pas supérieur à la première valeur et n'est pas inférieur à la seconde valeur, le modificateur d'indice différentiel est conçu pour ne pas modifier un indice différentiel pour la Nième bande, et

le seuil est le même que celui utilisé dans un appareil de décodage.

2. Appareil de décodage audio/vocal comprenant :

un récepteur pour recevoir des signaux audio/vocal codés transmis par un appareil de codage audio/vocal ;

un processeur ;

une mémoire ;

un sélecteur de table de Huffman (1401) conçu pour sélectionner une table de Huffman en fonction d'un signal de drapeau indiquant la table de Huffman sélectionnée par l'appareil de codage audio/vocal ;

un décodeur de Huffman (1402) conçu pour décoder les indices différentiels entre un Nième indice de bande et un (N-1)ième indice de bande, où N est un nombre entier de 1 ou plus, reçu par l'appareil de codage audio/parole, à l'aide de la table de Huffman sélectionnée ;

un reconstructeur d'indices différentiels (1403) conçu pour reconstruire un Nième indice différent décodé à l'aide de la table de Huffman sélectionnée lorsque N est un nombre entier de 2 ou plus, et remplace l'indice différentiel par l'indice différentiel reconstruit, et conçu pour ne pas reconstruire le Nième indice différentiel lorsque N est un nombre entier de 1 ;

un calculateur d'indices (1404) conçu pour calculer les indices de quantification à l'aide des indices différentiels reconstruits ;

un déquantificateur conçu pour déquantifier un niveau de facteurs de norme pour chaque bande ; et

un transformateur conçu pour transformer un spectre décodé généré à l'aide du facteur de normalisation pour chaque bande dans un domaine de fréquence en un signal dans le domaine temporel,

**caractérisé par le fait que**

lorsque l'indice différentiel décodé de la (N-1)ième bande est supérieur à une première valeur, le reconstructeur d'indices différentiels est conçu pour reconstruire un indice différentiel pour une Nième bande en soustrayant une valeur soustraite déterminée en soustrayant la première valeur d'un indice différentiel pour une (N-1)ième bande,

lorsque l'indice différentiel décodé d'une (N-1)ième bande est inférieur à une seconde valeur, le reconstructeur d'indices différentiels est conçu pour reconstruire un indice différentiel pour une Nième bande en soustrayant une valeur soustraite déterminée par la soustraction de la seconde valeur d'un indice différentiel pour la (N-1)ième bande,

dans lequel la première valeur est une somme d'une valeur de décalage et d'une valeur de seuil, et la seconde valeur est une différence de la valeur de décalage et de la valeur de seuil, et la valeur de décalage est de 15,

dans lequel lorsque l'indice différentiel décodé d'une (N-1)ième bande n'est pas supérieur à la première valeur et n'est pas inférieur à la seconde valeur, le reconstructeur d'indices différentiels est conçu pour reconstruire un indice différentiel décodé pour la Nième bande, et

le seuil est le même que celui utilisé dans un appareil de codage.

3. Procédé de codage audio/vocal comprenant les opérations suivantes :

transformer, par un transformateur, un signal d'entrée audio/vocal dans le domaine temporel en un spectre de fréquences

diviser le spectre de fréquences en plusieurs bandes ;

calculer un niveau de facteurs normatifs pour chaque bande ;

quantifier les facteurs de normalité pour chaque bande ;

calculer des indices différentiels entre un Nième indice de bande et un (N-1)ième indice de bande, où N est un nombre entier de 1 ou plus ;

modifier une plage d'indices différentiels pour la Nième bande lorsque N est un entier de 2 ou plus, et remplacer l'indice différentiel par l'indice différentiel modifié et ne pas modifier la plage d'indices différentiels pour la Nième bande lorsque N est un entier de 1 ;

coder les indices différentiels en utilisant une table de Huffman sélectionnée ; et

transmettre les indices différentiels codés et un signal de drapeau pour indiquer la table de Huffman sélectionnée à un appareil de décodage audio/parole,

**caractérisé par le fait que**

lorsque l'indice différentiel calculé de la (N-1)ième bande est supérieur à une première valeur, un indice différentiel pour une Nième bande est modifié en ajoutant une valeur soustraite déterminée en soustrayant la première valeur d'un indice différentiel pour une (N-1)ième bande, dans lequel lorsque l'indice différentiel calculé d'une (N-1)ième bande est inférieur à une seconde valeur, un indice différentiel pour une Nième bande est modifié en ajoutant une valeur soustraite déterminée en soustrayant la seconde valeur d'un indice différentiel pour la (N-1)ième bande, la première valeur est une somme d'une valeur de décalage et d'une valeur de seuil, et la seconde valeur est une différence de la valeur de décalage et de la valeur de seuil, et la valeur de décalage est de 15, et lorsque l'indice différentiel calculé d'une (N-1)ième bande n'est pas supérieur à la première valeur et n'est pas inférieur à la seconde valeur, l'indice différentiel de la Nième bande n'est pas modifié, et le seuil est le même que celui utilisé dans un appareil de décodage.

4. Procédé de décodage audio/vocal comprenant les opérations suivantes :

recevoir des signaux audio/vocal codés transmis par un appareil de codage audio/vocal ;

sélectionner une table de Huffman en fonction d'un signal de drapeau pour indiquer la table de Huffman sélectionnée par l'appareil de codage audio/vocal;

décoder les indices différentiels entre un Nième indice de bande et un (N-1)ième indice de bande, où N est un nombre entier de 1 ou plus, reçus par l'appareil de codage audio/parole, en utilisant la table de Huffman sélectionnée;

reconstruire un Nième indice différent décodé à l'aide de la table de Huffman sélectionnée lorsque N est un entier de 2 ou plus, et remplacer l'indice différentiel par l'indice différentiel reconstruit, et ne pas reconstruire le Nième indice différentiel lorsque N est un entier de 1 ;

calculer des indices de quantification à l'aide des indices différentiels reconstruits;

requantifier, par un quantificateur, un niveau de facteurs de norme pour chaque bande ; et

transformer un spectre décodé généré à l'aide des facteurs de normalisation pour chaque bande

dans le domaine des fréquences à un signal dans le domaine temporel,

**caractérisé par le fait que**

lorsque l'indice différentiel de la (N-1)ième bande est supérieur à une première valeur, un indice différentiel pour une Nième bande est reconstruit en soustrayant une valeur soustraite déterminée en soustrayant la première valeur d'un indice différentiel pour une (N-1)ième bande, où lorsque l'indice différentiel décodé d'une (N-1)ième bande est inférieur à une seconde valeur, un indice différentiel pour une Nième bande est reconstruit en soustrayant une valeur soustraite déterminée en soustrayant la seconde valeur d'un indice différentiel pour la (N-1)ième bande, où la première valeur est une somme d'une valeur de décalage et d'une valeur de seuil, et la seconde valeur est une différence de la valeur de décalage et de la valeur de seuil, et la valeur de décalage est de 15, où lorsque l'indice différentiel décodé d'une (N-1)ième bande n'est pas supérieur à la première valeur et n'est pas inférieur à la seconde valeur, un indice différentiel décodé pour la Nième bande est reconstruit, et le seuil est le même que celui utilisé dans un appareil de codage.

Encoder

Decoder

FIG. 1

| Index | Code | Index | Code | Index | Code | Index | Code |
|---|---|---|---|---|---|---|---|
| 0 | $2^{17.0}$ | 10 | $2^{12.0}$ | 20 | $2^{7.0}$ | 30 | $2^{2.0}$ |
| 1 | $2^{16.5}$ | 11 | $2^{11.5}$ | 21 | $2^{6.5}$ | 31 | $2^{1.5}$ |
| 2 | $2^{16.0}$ | 12 | $2^{11.0}$ | 22 | $2^{6.0}$ | 32 | $2^{1.0}$ |
| 3 | $2^{15.5}$ | 13 | $2^{10.5}$ | 23 | $2^{5.5}$ | 33 | $2^{0.5}$ |
| 4 | $2^{15.0}$ | 14 | $2^{10.0}$ | 24 | $2^{5.0}$ | 34 | $2^{0.0}$ |
| 5 | $2^{14.5}$ | 15 | $2^{9.5}$ | 25 | $2^{4.5}$ | 35 | $2^{-0.5}$ |
| 6 | $2^{14.0}$ | 16 | $2^{9.0}$ | 26 | $2^{4.0}$ | 36 | $2^{-1.0}$ |
| 7 | $2^{13.5}$ | 17 | $2^{8.5}$ | 27 | $2^{3.5}$ | 37 | $2^{-1.5}$ |
| 8 | $2^{13.0}$ | 18 | $2^{8.0}$ | 28 | $2^{3.0}$ | 38 | $2^{-2.0}$ |
| 9 | $2^{12.5}$ | 19 | $2^{7.5}$ | 29 | $2^{2.5}$ | 39 | $2^{-2.5}$ |

FIG. 2

FIG. 3

| Index | Code | Index | Code | Index | Code | Index | Code |
|-------|---------|-------|---------|-------|--------|-------|---------|
| 0 | 0011010 | 8 | 001100 | 16 | 000 | 24 | 0011110 |
| 1 | 0111010 | 9 | 011100 | 17 | 010 | 25 | 0111110 |
| 2 | 1011010 | 10 | 101100 | 18 | 1010 | 26 | 1011110 |
| 3 | 1111010 | 11 | 111100 | 19 | 1110 | 27 | 1111110 |
| 4 | 0011011 | 12 | 0010 | 20 | 001110 | 28 | 0011111 |
| 5 | 0111011 | 13 | 0110 | 21 | 011110 | 29 | 0111111 |
| 6 | 1011011 | 14 | 100 | 22 | 101110 | 30 | 1011111 |
| 7 | 1111011 | 15 | 110 | 23 | 111110 | 31 | 1111111 |

FIG. 4

FIG. 5

**Table 6.1**

| Flag | Huffman table range |
|------|---------------------|
| 00 | 13-17 |
| 01 | 12-18 |
| 10 | 11-19 |
| 11 | 10-20 |

**Table 6.2**

| Index | Code |
|-------|------|
| 13 | 110 |
| 14 | 00 |
| 15 | 01 |
| 16 | 10 |
| 17 | 111 |

FIG. 6A

Table 6.3

| Index | Code |
|-------|------|
| 12 | 1100 |
| 13 | 1101 |
| 14 | 01 |
| 15 | 00 |
| 16 | 10 |
| 17 | 1110 |
| 18 | 1111 |

Table 6.4

| Index | Code |
|-------|------|
| 11 | 0110 |
| 12 | 1110 |
| 13 | 1100 |
| 14 | 10 |
| 15 | 00 |
| 16 | 010 |
| 17 | 1101 |
| 18 | 1111 |
| 19 | 0111 |

Table 6.5

| Index | Code |
|-------|------|
| 10 | 1010 |
| 11 | 0110 |
| 12 | 1110 |
| 13 | 1100 |
| 14 | 100 |
| 15 | 00 |
| 16 | 010 |
| 17 | 1101 |
| 18 | 1111 |
| 19 | 0111 |
| 20 | 1011 |

FIG. 6B

FIG. 7

FIG. 8

FIG. 9

$$Range = [Min(Diff\_index(n)), Max(Diff\_index(n))]$$

FIG. 10

Encoder

{Energy(n)} → Psychoacoustic Model ⟋1101

↓ {Mask(n)}

{Index(n)} → Modification of Index — {New_index(n)} → Difference ⟋1103 → Check range ⟋1104 → Select Huffman Code table ⟋1105 → Flag to indicate the Huffman Code table

{New_index(n-1)} ↓ (to Difference 1103)

Huffman tables ↓ (to Select Huffman Code table 1105)

Range

{New_diff_index(n)} ↓ Restore Differential Indices ⟋1107 → Huffman Coding ⟋1108 → Coded index

{Index(n-1)} ↓

{Index(n)} → Difference ⟋1106 — {Diff_index(n)} →

{Res_diff_index(n)}

**FIG. 11**

{Energy(n)}  Threshold

{New_index(n-1)}

Huffman tables

{Index(n)} → Modification of Index ⟋1201 — {New_index(n)} → Difference ⟋1202 → Check range ⟋1203 → Select Huffman Code table ⟋1204 → Flag to indicate the Huffman Code table

Range

{Diff_index(n)} → Huffman Coding ⟋1205 → Coded index

**FIG. 12**

EP 3 594 943 B1

{Index(n-1)}

Threshold

Huffman tables

{Index(n)} → **difference** 1301 → {Diff_index(n)} → **Modification of differential indices** 1302 → {Diff_index_new(n)} → **Check range** 1303 → Range → **Select Huffman Code table** 1304

→ **Huffman Coding** 1305

FIG. 13

{Index(n)}

1404

{Index(n-1)} → sum

{Diff_index(n)}

1403

Threshold → Reconstruction of differential indices ← {Diff_index(n-1)}

{Diff_index_new(n)}

1401

Select Huffman Code table

1402

Huffman Coding

Flag to indicate the Huffman Code table

Coded index

FIG. 14

26

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002268693 A